# EUROPÄISCHE PATENTSCHRIFT

(11) **EP 3 275 078 B1**
(45) Veröffentlichungstag und Bekanntmachung des Hinweises auf die Patenterteilung: **27.05.2026**
(21) Anmeldenummer: 16711245.7
(22) Anmeldetag: 18.03.2016
(51) Int. Cl.: H03H 7/01, H03H 7/09, H03K 17/16

(54) **SCHALTUNGSANORDNUNG ZUR DÄMPFUNG EINES VON EINER ELEKTRISCHEN STÖRQUELLE VERURSACHTEN ELEKTRISCHEN STÖRSIGNALS**
CIRCUIT ARRANGEMENT FOR ATTENUATING AN ELECTRICAL INTERFERENCE SIGNAL WHICH IS CAUSED BY AN ELECTRICAL INTERFERENCE SOURCE
ENSEMBLE COMMUTATEUR DESTINÉ À L'ATTÉNUATION D'UN SIGNAL BROUILLEUR ÉLECTRIQUE GÉNÉRÉ PAR UNE SOURCE DE BROUILLAGE ÉLECTRIQUE

(30) Priorität: 26.03.2015 DE 102015205515
(43) Veröffentlichungstag der Anmeldung: 31.01.2018
(73) Patentinhaber: VARTA Microbattery GmbH, 73479 Ellwangen Jagst (DE)
(72) Erfinder: KLOOS, Dieter, 74579 Fichtenau (DE)
(74) Vertreter: Ostertag & Partner Patentanwälte mbB
(86) Internationale Anmeldenummer: PCT/EP2016/056029
(87) Internationale Veröffentlichungsnummer: WO 2016/150874

(56) Entgegenhaltungen:
- WO-A1-2004/079902
- WO-A1-2006/024198
- DE-A1- 1 800 401
- FR-A1- 2 786 337
- US-A- 5 687 067
- US-A1- 2013 107 584
- US-B1- 6 473 318
- VIKTOR D VOGMAN: "Power Nondissipative Clamping Benefi ts DC-DC Converters", 30 September 2005 (2005-09-30), pages 26 - 30, XP055166117, Retrieved from the Internet <URL:http://powerelectronics.com/site-files/powerelectronics.com/files/archive/powerelectronics.com/images/509PET22.pdf> [retrieved on 20150130]

## Beschreibung

Die Erfindung betrifft eine Schaltungsanordnung zur Dämpfung eines von einer elektrischen Störquelle verursachten elektrischen Störsignals.

Eine Schaltungsanordnung zur Dämpfung eines von einer elektrischen Störquelle verursachten elektrischen Störsignals ist aus der US 2013/107584 A1 bekannt. Hier wird ein MOSFET-Gate-Treiber-System beschrieben, das sowohl den Einschaltwiderstand als auch den Ausschaltwiderstand eines Gate-Treibers innerhalb eines einzigen Schaltzyklus dynamisch anpasst, um elektromagnetische Interferenzen im System zu reduzieren.

Aus der US 5687067 A ist eine Steuerung zur Bereitstellung eines Schaltsignals zur Steuerung des Schaltens eines Halbleiter-Leistungsbauelements in einem pulsweitenmodulierten Wandler bekannt. Der Controller formt die Wellenform des Schaltsignals so, dass der Grad der elektromagnetischen Interferenz oder des Rauschens, das durch das Schalten des Halbleiter-Leistungsbauelements des Konverters erzeugt und abgestrahlt wird, reduziert wird.

Aus der Veröffentlichung von Viktor D. Vogman "Nondissipative Clamping Benefits DC-DC Converters" (Power Electronics Technology, 30. September 2005, Seiten 26-30) geht eine Klemmschaltung für einen Durchfluss- und Sperrwandler hervor, bei der ein Kondensator und eine Diode für eine verlustfreie Spannungsbegrenzung sorgen.

Aus der WO 2006/024198 A1 ist eine Dämpfungsschaltung mit einer Energierückkopplungsschaltung bekannt. Der Energierückkopplungskreis umfasst einen Transformator, wobei das Ende der Primärwicklung des Transformators zwischen einer Diode und einem Kondensator und das andere Ende der Primärwicklung zwischen einem Schaltelement und einer weiteren Diode angeschlossen ist und wobei der Eingang eines Brückengleichrichters parallel zur Sekundärwicklung des Transformators und der Ausgang des Brückengleichrichters parallel zur Leistung koppelt.

Aus der US 6473318 B1 ist ein Sperrwandler mit angeschlossener Streuenergierückgewinnung bekannt.

Die DE 1 800 401 A1 zeigt eine Schaltungsanordnung mit einem in Reihe zur Primärwicklung eines Transformators angeordneten Kondensator zur Beeinflussung des Stromverlaufs. Offenbart ist eine herkömmliche Schaltung zur Spannungs- und Strombegrenzung. Von einer selektive Abkopplung hochfrequenter Störanteile von einer geschalteten induktiven Last ist keine Rede.

Die FR 2 786 337 A1 offenbart eine Schaltung mit Übertrager und Reihenkondensator zur Signalübertragung. Sie betrifft vornehmlich Kommunikations- oder Messsignale.

Die WO 2004/079902 A1 beschreibt eine Entstörschaltung mit Kondensator und Übertrager zur elektromagnetischen Verträglichkeit (EMV) von Schaltnetzteilen. Der Kondensator dient dabei der allgemeinen Störunterdrückung und Spannungsbegrenzung.

Es ist die Aufgabe der Erfindung, eine Schaltungsanordnung zur Dämpfung eines von einer elektrischen Störquelle verursachten elektrischen Störsignals zur Verfügung zu stellen, die möglichst universell für verschiedenste Störsignale einsetzbar ist und die in möglichst beliebige Schaltungstopologien integrierbar ist.

Die Erfindung löst diese Aufgabe durch eine Schaltungsanordnung nach Anspruch 1.

Die erfindungsgemäße Schaltungsanordnung ist zur Dämpfung und/oder Begrenzung eines von einer elektrischen Störquelle verursachten elektrischen Störsignals ausgebildet.

Bei der Störquelle handelt es sich um eine geschaltete induktive Last.

Die Schaltungsanordnung weist einen Eingangsanschlusspol auf, der dazu vorgesehen ist, mit der Störquelle mittelbar oder unmittelbar elektrisch verbunden zu werden, so dass er mit dem Störsignal oder mit einem aus dem Störsignal hervorgehenden Signal beaufschlagt ist. Die Schaltungsanordnung kann einen weiteren bzw. zweiten Eingangsanschlusspol aufweisen, der mit einem Bezugspotential einer Schaltung verbunden sein kann, in die die erfindungsgemäße Schaltungsanordnung integriert ist.

Die Schaltungsanordnung weist weiter einen Rückspeisanschlusspol auf, an dem ein Rückspeisesignal ausgegeben wird bzw. ansteht, das mittels der Schaltungsanordnung aus dem Störsignal erzeugt ist.

Die Schaltungsanordnung weist weiter einen Übertrager mit mindestens einer Primärwicklung und mindestens einer Sekundärwicklung auf. Die Primärwicklung ist elektrisch mit dem Eingangsanschlusspol unmittelbar (d.h. ohne weitere zwischengeschaltete Bauelemente) oder mittelbar (d.h. mit weiteren, zwischengeschalteten Bauelementen) gekoppelt. Die Sekundärwicklung oder die Sekundärwicklungen ist/sind elektrisch unmittelbar oder mittelbar mit dem Rückspeisanschlusspol gekoppelt.

Die Schaltungsanordnung weist einen DC-Entkopplungskondensator auf, wobei der DC-Entkopplungskondensator und die Primärwicklung in Reihe zwischen den Eingangsanschlusspol und ein Bezugspotential der Schaltungsanordnung, beispielsweise Massepotential, eingeschleift sind.

Die Schaltungsanordnung kann einen Gleichrichter aufweisen, der dazu ausgebildet ist, ein an der Sekundärwicklung anstehendes Signal gleichzurichten, wobei das gleichgerichtete Signal an dem Rückspeisanschlusspol zur Energierückspeisung ausgegeben wird.

Der Gleichrichter kann ein (Voll-) Brückengleichrichter sein.

Der Übertrager kann eine erste Sekundärwicklung und eine zweite Sekundärwicklung aufweisen, wobei für diesen Fall die Schaltungsanordnung einen Mittelpunktgleichrichter aufweisen kann, der dazu ausgebildet ist, ein an der ersten Sekundärwicklung anstehendes Signal gleichzurichten und ein an der zweiten Sekundärwicklung anstehendes Signal gleichzurichten, wobei die gleichgerichteten Signale an dem Rückspeisanschlusspol zur Energierückspeisung ausgegeben werden.

Der Übertrager kann ein galvanisch trennender Übertrager sein.

Die erfindungsgemäße Schaltungsanordnung eignet sich zur Trennung des Störsignals von einem Nutzsignal und weiterhin der Nutzbarmachung der Energie des Störsignals als rückspeisbare Nutzenergie.

Die Schaltungsanordnung ist universell einsetzbar und dazu in der Lage, die Energie von Störströmen und Störspannungen in nutzbare bzw. rückspeisbare Energie umzusetzen.

Die Entnahme von Störenergie durch die erfindungsgemäße Schaltungsanordnung geschieht vorzugsweise galvanisch getrennt, wodurch die gewonnene Energie verschiedenen Kreisen mit beliebigen Potentialdifferenzen zugeführt werden kann.

Die erfindungsgemäße Schaltungsanordnung kann auch nachträglich an eine bestehende Schaltung bzw. Baugruppe angeschlossen bzw. darin integriert werden, womit der Wirkungsgrad der Schaltung bzw. Baugruppe erhöht werden kann. Es ist hierbei nicht notwendig, substantiell in die bestehende Schaltung bzw. Baugruppe einzugreifen, da für die Integration der erfindungsgemäßen Schaltungsanordnung in die bestehende Schaltung bzw. Baugruppe keine Komponenten der Schaltung bzw. Baugruppe, wie beispielsweise Transformatoren, modifiziert werden müssen.

Die erfindungsgemäße Schaltungsanordnung kann einen Gleichrichter aufweisen und dadurch die Nutzbarmachung von Störsignalen beliebiger Polarität ermöglichen.

Die erfindungsgemäße Schaltungsanordnung kann aus wenigen und kostengünstigen Bauelementen einfach realisiert werden.

Die erfindungsgemäße Schaltungsanordnung arbeitet rein passiv. Es ist keine Steuerung oder Regelung durch spezielle Steuersignale erforderlich, wodurch die Schaltungsanordnung sehr einfach gehalten werden kann.

Die Erfindung wird nachfolgend unter Bezugnahme auf die Zeichnungen detailliert beschrieben. Hierbei zeigen schematisch:
- Fig. 1: eine erfindungsgemäße Schaltungsanordnung zur Dämpfung eines von einer elektrischen Störquelle verursachten elektrischen Störsignals gemäß einer ersten Ausführungsform und
- Fig. 2: eine erfindungsgemäße Schaltungsanordnung zur Dämpfung eines von einer elektrischen Störquelle verursachten elektrischen Störsignals gemäß einer weiteren Ausführungsform.

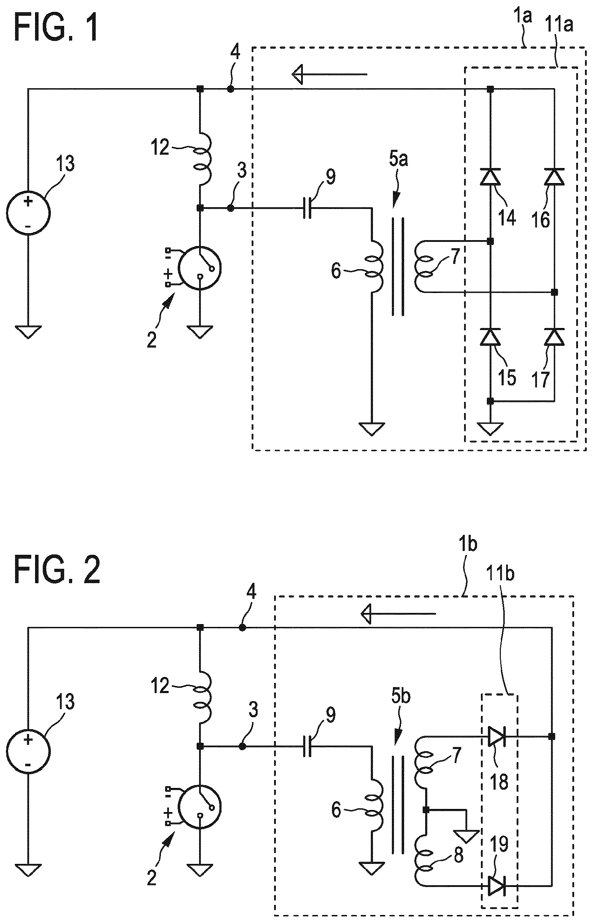

Fig. 1 zeigt eine erfindungsgemäße Schaltungsanordnung 1a zur Dämpfung eines von einer elektrischen Störquelle 2 verursachten elektrischen Störsignals gemäß einer ersten Ausführungsform.

Die Schaltungsanordnung 1a weist einen Eingangsanschlusspol 3 auf, der dazu vorgesehen ist, mit der Störquelle 2 in Form eines getakteten Schaltmittels elektrisch verbunden zu werden. Das getaktete Schaltmittel 2 verbindet in seinem geschlossenen Schaltzustand eine Induktivität 12 mit einem Bezugspotential, beispielsweise dem Massepotential. Durch das Schalten der Induktivität 12 wird an dem Verbindungsknoten zwischen der Induktivität 12 und dem Schaltmittel 2 ein Störsignal verursacht, welches von der Schaltungsanordnung 1a gedämpft wird. Die Energie des Störsignals wird zumindest teilweise mittels der Schaltungsanordnung 1a zurückgespeist. Der Eingangsanschlusspol 3 ist hierzu mit einem Verbindungsknoten zwischen der Induktivität 12 und dem Schaltmittel 2 verbunden.

Die Schaltungsanordnung 1a weist weiter einen Rückspeisanschlusspol 4 auf, an dem ein Rückspeisesignal ausgegeben wird, das aus dem Störsignal erzeugt ist.

Die Schaltungsanordnung 1a ist mit ihrem Eingangsanschlusspol 3 und ihrem Rückspeisanschlusspol 4 mit einer umgebenden Schaltung verbunden, die vorliegend exemplarisch das Schaltmittel 2, die Induktivität 12 und eine Versorgungsspannungsquelle 13 aufweist. Die umgebende Schaltung und die erfindungsgemäße Schaltungsanordnung 1a weisen ein gemeinsames Bezugspotential, beispielsweise Massepotential, auf.

Der Rückspeisanschlusspol 4 ist mit einem positiven Anschlusspol der Versorgungsspannungsquelle 13 elektrisch gekoppelt.

Die Schaltungsanordnung 1a weist weiter einen galvanisch trennenden Übertrager 5a mit einer einzelnen Primärwicklung 6 und einer einzelnen Sekundärwicklung 7 auf.

Ein DC-Entkopplungskondensator 9 der Schaltungsanordnung 1a und die Primärwicklung 6 sind in Reihe zwischen den Eingangsanschlusspol 3 und das Bezugspotential eingeschleift.

Die Schaltungsanordnung 1a weist weiter einen Brückengleichrichter 11a mit Dioden 14 bis 17 auf. Zwischen den Rückspeisanschlusspol 4 und einen ersten Anschlusspol der Sekundärwicklung 7 ist die Diode 14 in Durchlassrichtung eingeschleift. Zwischen den Rückspeisanschlusspol 4 und einen zweiten Anschlusspol der Sekundärwicklung 7 ist die Diode 16 in Durchlassrichtung eingeschleift. Zwischen den ersten Anschlusspol der Sekundärwicklung 7 und das Bezugspotential ist die Diode 15 in Sperrrichtung eingeschleift. Zwischen den zweiten Anschlusspol der Sekundärwicklung 7 und das Bezugspotential ist die Diode 17 in Sperrrichtung eingeschleift. Der Brückengleichrichter 11a ist dazu ausgebildet, ein an der Sekundärwicklung 7 anstehendes Signal gleichzurichten und an dem Rückspeisanschlusspol 4 auszugeben.

Fig. 2 zeigt eine erfindungsgemäße Schaltungsanordnung 1b zur Dämpfung eines von der elektrischen Störquelle 2 verursachten elektrischen Störsignals gemäß einer weiteren Ausführungsform. Die Schaltungsanordnung 1b entspricht eingangsseitig der Schaltungsanordnung 1a, so dass insoweit auf das oben Ausgeführte verwiesen sei, um Wiederholungen zu vermeiden.

Der Übertrager 5b weist neben der (ersten) Sekundärwicklung 7 eine weitere, zweite Sekundärwicklung 8 auf. Zur Gleichrichtung der Signale an den Sekundärwicklungen 7 und 8 ist ein Mittelpunktgleichrichter 11b mit Dioden 18 und 19 vorgesehen.

Ein sekundärseitiger Mittenabgriff des Übertragers 5b, an dem erste Anschlusspole der Sekundärwicklungen 7 und 8 elektrisch miteinander verbunden sind, ist mit dem Bezugspotential elektrisch verbunden. Zwischen den Rückspeisanschlusspol 4 und einen zweiten Anschlusspol der ersten Sekundärwicklung 7 ist die Diode 18 in Durchlassrichtung eingeschleift. Zwischen den Rückspeisanschlusspol 4 und einen zweiten Anschlusspol der zweiten Sekundärwicklung 8 ist die Diode 19 in Durchlassrichtung eingeschleift.

Bei der in Fig. 2 gezeigten Schaltungsanordnung 1b werden die Spannungsspitzen, die beim Schalten der Induktivität 12 entstehen, über den DC-Entkopplungskondensator 9 auf die Primärwicklung 6 des Übertragers 5b gegeben. Die Dioden 18 und 19 richten das übertragene Signal gleich und speisen es über den Rückspeisanschlusspol 4 in die versorgende Quelle 13 zurück.

Bei der in Fig. 1 gezeigten Schaltungsanordnung wird anstelle des Mittelpunktgleichrichters 11b ein Brückengleichrichter 11a verwendet. In diesem Fall wird die Konstruktion des Übertragers 5a einfacher, aber die Effizienz der Schaltungsanordnung ist aufgrund der doppelten Anzahl der Diodenstrecken geringer.

## Patentansprüche

1. Schaltungsanordnung (1a, 1b) zur Dämpfung eines von einer elektrischen Störquelle (2), bei der es sich um eine geschaltete induktive Last (12) handelt, verursachten elektrischen Störsignals, aufweisend:
- einen Eingangsanschlusspol (3), der mit einem Verbindungsknoten zwischen der Induktivität (12) und dem Schaltmittel (2) verbunden ist,
- einen Rückspeisanschlusspol (4), an dem ein Rückspeisesignal ausgegeben wird, das aus dem Störsignal erzeugt ist, und
- einen Übertrager (5a, 5b) mit einer Primärwicklung (6) und mindestens einer Sekundärwicklung (7, 8),
- wobei die Primärwicklung (6) elektrisch mit dem Eingangsanschlusspol (3) gekoppelt ist, und
- wobei die mindestens eine Sekundärwicklung (7, 8) elektrisch mit dem Rückspeisanschlusspol (4) gekoppelt ist,
- der Rückspeisanschlusspol (4) ist mit einem positiven Anschlusspol der Versorgungsspannungsquelle (13) elektrisch gekoppelt,
- die Schaltungsanordnung (1a, 1b) einen DC-Entkopplungskondensator (9) aufweist, der zusammen mit der Primärwicklung (6) in Reihe zwischen den Eingangsanschlusspol (3) und ein Bezugspotential eingeschleift ist, wobei der DC-Entkopplungskondensator (9) dazu ausgebildet ist, die beim Schalten der induktiven Last entstehenden hochfrequenten Spannungsspitzen auf die Primärwicklung (6) zu koppeln.

2. Schaltungsanordnung (1a, 1b) nach Anspruch 1, **gekennzeichnet durch**
- einen Gleichrichter (11a, 11b), der dazu ausgebildet ist, ein an der Sekundärwicklung (7, 8) anstehendes Signal gleichzurichten, wobei das gleichgerichtete Signal an dem Rückspeisanschlusspol (4) ausgegeben wird.

3. Schaltungsanordnung (1a) nach Anspruch 2, **dadurch gekennzeichnet, dass**
- der Gleichrichter ein Brückengleichrichter (11a) ist.

4. Schaltungsanordnung (1b) nach einem der vorhergehenden Ansprüche, **dadurch gekennzeichnet, dass**
- der Übertrager (5b) eine erste Sekundärwicklung (7) und eine zweite Sekundärwicklung (8) aufweist.

5. Schaltungsanordnung (1b) nach Anspruch 4, **gekennzeichnet durch**
- einen Mittelpunktgleichrichter (11b), der dazu ausgebildet ist, ein an der ersten Sekundärwicklung (7) anstehendes Signal gleichzurichten und ein an der zweiten Sekundärwicklung (8) anstehendes Signal gleichzurichten, wobei die gleichgerichteten Signale an dem Rückspeisanschlusspol (4) ausgegeben werden.

6. Schaltungsanordnung (1a, 1b) nach einem der vorhergehenden Ansprüche, **dadurch gekennzeichnet, dass**
- der Übertrager (5a, 5b) ein galvanisch trennender Übertrager ist.

## Claims

1. Circuit arrangement (1a, 1b) for attenuating an electrical interference signal caused by an electrical interference source (2), which is a switched inductive load (12), comprising:
- an input connection pole (3) connected to a connection node between the inductor (12) and the switching element,
- a feedback connection pole (4) at which a feedback signal generated from the interference signal is output, and
- a transformer (5a, 5b) having a primary winding (6) and at least one secondary winding (7, 8),
- wherein the primary winding (6) is electrically coupled to the input connection pole (3), and
- wherein the at least one secondary winding (7, 8) is electrically coupled to the feedback connection pole (4), and
- the feedback connection pole (4) is electrically coupled to a positive terminal of the supply voltage source (13), and
- the circuit arrangement (1a, 1b) comprises a DC decoupling capacitor (9) which, together with the primary winding (6), is connected in series between the input connection pole (3) and a reference potential, wherein the DC decoupling capacitor (9) is configured to couple high-frequency voltage spikes generated during switching of the inductive load to the primary winding (6).

2. Circuit arrangement (1a, 1b) according to claim 1, **characterized by**
- a rectifier (11a, 11b) configured to rectify a signal present at the secondary winding (7, 8), wherein the rectified signal is output at the feedback connection pole (4).

3. Circuit arrangement (1a) according to claim 2, **characterized in that**
- the rectifier is a bridge rectifier (11a).

4. Circuit arrangement (1b) according to one of the preceding claims, **characterized in that**
- the transformer (5b) comprises a first secondary winding (7) and a second secondary winding (8).

5. Circuit arrangement (1b) according to claim 4, **characterized by**
- a center-tapped rectifier (11b) configured to rectify a signal present at the first secondary winding (7) and to rectify a signal present at the second secondary winding (8), wherein the rectified signals are output at the feedback connection pole (4).

6. Circuit arrangement (1a, 1b) according to one of the preceding claims, **characterized in that**
- the transformer (5a, 5b) is a galvanically isolating transformer.

## Revendications

1. Agencement de circuit (1a, 1b) destiné à atténuer un signal de brouillage électrique provoqué par une source de brouillage électrique (2), laquelle est une charge inductive commutée (12), comportant :
- une borne d'entrée (3) reliée à un nœud de liaison entre l'inductance (12) et le moyen de commutation (2),
- une borne de retour (4) sur laquelle est délivré un signal de retour généré à partir du signal de brouillage, et
- un transformateur (5a, 5b) comprenant un enroulement primaire (6) et au moins un enroulement secondaire (7, 8),
- l'enroulement primaire (6) étant couplé électriquement à la borne d'entrée (3), et
- ledit au moins un enroulement secondaire (7, 8) étant couplé électriquement à la borne de retour (4),
- la borne de retour (4) étant couplée électriquement à une borne positive de la source de tension d'alimentation (13),
- l'agencement de circuit (1a, 1b) comportant un condensateur de découplage DC (9) qui est inséré en série avec l'enroulement primaire (6) entre la borne d'entrée (3) et un potentiel de référence, le condensateur de découplage DC (9) étant conçu pour coupler à l'enroulement primaire (6) des pics de tension à haute fréquence générés lors de la commutation de la charge inductive.

2. Agencement de circuit (1a, 1b) selon la revendication 1, **caractérisé par**
- un redresseur (11a, 11b) conçu pour redresser un signal présent sur l'enroulement secondaire (7, 8), le signal redressé étant délivré sur la borne de retour (4).

3. Agencement de circuit (1a) selon la revendication 2, **caractérisé en ce que**
- le redresseur est un pont redresseur (11a).

4. Agencement de circuit (1b) selon l'une quelconque des revendications précédentes, **caractérisé en ce que**
- le transformateur (5b) comporte un premier enroulement secondaire (7) et un deuxième enroulement secondaire (8).

5. Agencement de circuit (1b) selon la revendication 4, **caractérisé par**
- un redresseur à point milieu (11b) conçu pour redresser un signal présent sur le premier enroulement secondaire (7) et pour redresser un signal présent sur le deuxième enroulement secondaire (8), les signaux redressés étant délivrés sur la borne de retour (4).

6. Agencement de circuit (1a, 1b) selon l'une quelconque des revendications précédentes, **caractérisé en ce que**
- le transformateur (5a, 5b) est un transformateur à isolation galvanique.
